# EUROPÄISCHE PATENTANMELDUNG

(11) **EP 0 902 537 A2**
(43) Veröffentlichungstag der Anmeldung: **17.03.1999**
(21) Anmeldenummer: 98116595.4
(22) Anmeldetag: 02.09.1998
(51) Int. Cl.: H03K 17/082

(54) **Schaltungsanordnung zur Begrenzung von Überspannungen bei Leistungshalbleitern**

(30) Priorität: 15.09.1997 DE 19740540
(71) Anmelder: SIEMENS AKTIENGESELLSCHAFT, 80333 München (DE)
(72) Erfinder: Bruckmann, Manfred, Dipl.-Ing., 90475 Nürnberg (DE); Eckel, Hans-Günter, Dr., 91052 Erlangen (DE)

(57) **Zusammenfassung**

Die Erfindung betrifft eine Schaltungsanordnung zur Begrenzung von dynamischen Überspannungen beim Abschalten von spannungsgesteuerten Leistungshalbleitern mit einer parallel zu der Kollektor-Gate-Strecke des Leistungshalbleiters angeordneten Spannungsklemmbeschaltung, umfassend zwei oder mehrere in Reihe geschaltete Zenerdioden; erfindungsgemäß ist wenigstens eine Zenerdiode durch einen Kondensator und/oder ein RC-Netzwerk überbrückt.

## Beschreibung

Die Erfindung betrifft eine Schaltungsanordnung zur Begrenzung von dynamischen Überspannungen beim Abschalten von spannungsgesteuerten Leistungshalbleitern mit einer parallel zu der Kollektor-Gate-Strecke des Leistungshalbleiters angeordneten Spannungsklemmbeschaltung, umfassend zwei oder mehrere in Reihe geschaltete Zenerdioden.

Spannungsgesteuerte Leistungshalbleiter, insbesondere Insulated Gate Bipolar-Transistoren (IGBT), aber auch Leistungs-MOSFET, werden üblicherweise zum Aufbau von Stromrichtern für die elektrische Antriebstechnik verwendet. Derartige Umrichter haben zumeist einen netzgeführten Gleichrichter zur Speisung eines Zwischenkreiskondensators, an den ein gesteuerter Stromrichter, bspw. in Form einer zweiphasigen Brückenschaltung, angekoppelt ist. Eine derartige Drehstrombrückenschaltung besteht aus drei zu dem Zwischenkreiskondensator parallel geschalteten Zweigen mit je zwei in Reihe liegenden Leistungshalbleitern. Diesen wird jeweils eine Freilaufdiode parallel geschaltet, so daß beim Abschalten eines Leistungshalbleiters der durch die Motorwicklung weitgehend konstant gehaltene Motorstrom durch die Freilaufdiode des jeweils anderen Leistungshalbleiters in demselben Brückenzweig weiterfließen kann. Bei einer derartigen Kommutierung von einem abschaltbaren Leistungshalbleiter auf eine zu diesen antiparallel liegende Freilaufdiode entsteht ein Kommutierungsstrom, dessen Stromkreis über den Zwischenkreiskondensator geschlossen wird. Die Kommutierung wird dadurch ausgelöst, daß die Kollektor-Ermitter-Spannung des abschaltbaren Leistungshalbleiters als Reaktion auf ein entsprechendes Ansteuersignal bis auf den wert der Zwischenkreisspannung ansteigt, so daß nun die betreffende Freilaufdiode in Durchlaßrichtung gepolt ist und allmählich den Strom des angeschlossenen Verbrauchers übernimmt. Infolge der Kirchhoff'sche Gesetze sinkt der Strom durch den abschaltbaren Leistungshalbleiter mit einem Ansteigen des Stroms durch die Freilaufdiode. Aufgrund der hierbei auftretenden, hohen Stromänderungsgeschwindigkeit treten gleichzeitig in den unvermeidlichen, parasitären Induktivitäten des oben angesprochenen Kommutierungskreises hohe Spannungsspitzen auf, welche sich der Zwischenkreisspannung additiv überlagern und von dem nun abgeschalteten Leistungshalbleiter aufgenommen werden müssen. Die Vermeidung derartiger Spannungspitzen ist eine wichtige Maßnahme zur Erhöhung der Lebensdauer des betreffenden Gerätes.

Hierfür wird in dem Aufsatz 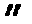 Switching Voltage Transient Protection Schemes For High Current IGBT Modules" von Rahul Chokhawala, Saed Sobhani in der Zeitschrift 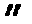 IEEE", Jahrgang 1994, Seiten 459 - 468, vorgeschlagen, zu der Kollektor-Emitter-Strecke der abschaltbaren Leistungshalbleiters eine Reihenschaltung aus einem Kondensator und einer in Durchlaßrichtung gepolten Diode parallel zu schalten, wobei ein zusätzlicher, zu der Diode paralleler Widerstand eine Entladung des Kondensators erlaubt. Ein derartiger, ausgangsseitig parallel geschalteter Kondensator mag zwar die Energie von Überspannungsspitzen aufnehmen, für eine effektive Begrenzung von Überspannungen im Abschalt- und insbesondere im Kurzschlußfall muß ein derartiger Kondensator jedoch relativ groß ausgelegt werden und ist somit unwirtschaftlich.

In demselben Aufsatz werden daher weitere Maßnahmen zur Begrenzung von dynamischen Überspannungen vorgeschlagen, welche dem betreffenden Leistungshalbleiter nicht ausgangsseitig parallel geschalten werden, sondern mit dessen Kollektor- und Gate-Anschluß gekoppelt sind, um durch eine geeignete Steuerung des Leistungshalbleiters das Auftreten von Überspannungen zu reduzieren.

Bei einer ersten Schaltungsvariante ist in Reihe zu einem zwischen dem Gateanschluß des Leistungshalbleiters und dem Treiberausgang der Ansteuerstufe eingeschalteten Gatewiderstands ein zweiter Widerstand angeordnet, der bei eingeschaltetem Leistungshalbleiter von einem MOSFET überbrückt wird. Steigt die Kollektorspannung des Leistungshalbleiters bei einem Abschaltvorgang an, wird der MOSFET nach einer vorgegebenen Verzögerungszeit gesperrt, und die weitere Ansteuerung des Gateanschlußes muß über die beiden, in Reihe geschalteten Gatewiderstände erfolgen, so daß der Abschaltvorgang verlangsamt wird. Infolge der daraus resultierenden, niedrigeren Stromänderungsgeschwindigkeit des Leistungshalbleiters wird die Amplitude von dynamischen Überspannungen zwar herabgesetzt, durch die verzögerte Sperrfähigkeit des Leistungshalbleiters werden jedoch die in diesem auftretenden Verluste erhöht, was eine zusätzliche, thermische Belastung mit sich bringt.

Eine ähnliche Wirkung hat eine andere Schaltungsanordnung, wo bei Überschreiten eines vorgegebenen Kollektorspannungspegels ein zusätzlicher Kondensator zwischen dem Gate- und dem Emitteranschluß des Leistungshalbleiters aktiviert wird, der ebenfalls verzögernd auf das Absinken der Steuerspannung an dem Gateanschluß wirkt und dadurch die Stromänderunggeschwindigkeit in dem Kommutierungskreis herabsetzt.

Schließlich wird in dieser Druckschrift eine aktive Spannungsklemmbeschaltung vorgeschlagen, wobei durch eine Zenerdiode zwischen dem Kollektor- und Gateanschluß des Leistungshalbleiters die Steuerspannung an dem Gateanschluß angehoben wird, sobald eine vorgegebene Kollektorspannung überschritten wird. Hierdurch wird der Leistungshalbleiter wieder - zumindest in begrenztem Umfang - aufgesteuert, so daß auftretende, dynamische Überspannungen von diesem kurzgeschlossen werden können. Dieses angestrebte Verhalten läßt sich jedoch in der Praxis mit der beschriebenen Schaltung nur unzureichend erzielen. Denn, um eine funktionssichere Schaltung zu erhalten, muß die Zenerspannung größer gewählt werden als die Zwischenkreispannung, so daß die Spannungsklemmbeschaltung überhaupt erst beim Auftreten von Überspannungen am Kollektoranschluß aktiv wird. Dies ist jedoch erst nach Verstreichen einer gewissen Abschaltverzögerungszeit der Fall, während der die Spannung am Gateanschluß bereits auf sehr niedrige Werte abgesunken ist. Nun muß über die Zenerdiode zunächst die parasitäre Gatekapazität wieder aufgeladen werden, bevor der Leistungshalbleiter wieder in den Durchlaßzustand gelangen kann. Inzwischen kann die Amplitude der Störspannungsspitze jedoch einen erheblichen Wert von mehr als 100 V erreichen, so daß diese Schaltung an einer prinzipbedingten Funktionsschwäche leidet, und die real erzielbaren Ergebnisse weit hinter der angestrebten, idealen Funktion zurückbleiben.

Deswegen wurde in der DE-OS 44 28 675 bereits vorgeschlagen, einen Meßwiderstand in die Spannungsklemmbeschaltung einzufügen und über den dortigen Spannungsabfall einen Stromfluß durch das Zenernetzwerk zu sensieren. Dieser Stromfluß wird über einen Regler in ein Steuersignal umgesetzt, welches dem Steuersignal für den Treiber der Ansteuerstufe aufgeschalten wird, so daß zur Umladung der parasitären Gatekapazität nicht der Zenerstrom, sondern der niederohmige Treiberausgang verwendet werden kann. Diese Schaltung führt zu einem relativ schnellen Ansprechen des Leistungshalbleiters nach Überschreiten einer vorgegebenen Kollektor-Gate-Spannung, welche einen Stromfluß in der Zener-Klemmbeschaltung zur Folge hat. Dennoch werden die Gegenmaßnahmen zur Bedämpfung einer dynamischen Überspannung erst eingeleitet, wenn die Kollektor-Emitter-Spannung an dem Leistungshalbleiter bereits die Zwischenkreisspannung erreicht hat und außerdem eine vorgegebene Überspannungsamplitude überschritten ist.

Deshalb sieht die DE-OS 44 28 674 vor, bereits mit Beginn des Abschaltvorgangs Gegenmaßnahmen einzuleiten. Hierzu wird einerseits die Gate-Emitter-Spannung, andererseits die Kollektor-Emitter-Spannung überwacht, um den Einschaltzustand des Leistungshalbleiters zu erkennen. Zur Erkennung eines Abschaltbefehls wird gleichzeitig das Steuersignal für den Treiberausgang der Ansteuerstufe überwacht. Mit Beginn einer Abschaltphase wird dem Steuersignal des Treiberbausteins eine zeitlich begrenzte Konstantspannung aufgeschalten, damit die Gate-Spannung des Leistungshalbleiters zunächst nur bis unterhalb der Einschaltschwelle abgesenkt wird. In diesem Zustand kann ein durch die Spannungsklemmbeschaltung fließender Zenerstrom den Gateanschluß schnell wieder über die Schaltschwelle des Leistungshalbleiters anheben, so daß eine Überspannung sehr schnell kurzgeschlossen werden kann. Nach Verstreichen einer vorgegebenen Zeitdauer ist die Gefahr einer Überspannung vorbei, und nun wird die Hilfsspannung von dem Steuereingang des Treiberbausteins weggenommen, so daß die Gatespannung des Leistunghalbleiters nun auf sichere Werte absinken kann. Diese Schaltungsanordnung ist während der gesamten Abschaltphase aktiv, um die Dynamik der Überspannungsbegrenzung zu verbessern. Dies bringt jedoch den Nachteil mit sich, daß der Ausschaltvorgang des Leistungshalbleiters insgesamt verzögert wird, was wiederum die Schaltverluste und somit die thermische Belastung des Leistungshalbleiters erhöht.

Aus diesen Nachteilen des vorbekannten Stands der Technik resultiert das die Erfindung initiierende Problem, bekannte Spannungsklemmbeschaltungen zwischen Kollektor- und Gateanschluß eines Leistungshalbleiters derart zu verbessern, daß dynamische Überspannungen möglichst vollständig unterdrückt werden können, ohne zu diesem Zweck den Abschaltvorgang zu verzögern; weitere Randbedingungen sind darin zu sehen, daß die von der Spannungsklemmbeschaltung verursachten Verluste so gering als möglich sein sollen, und außerdem soll der Bauteileaufwand auf ein Minimum reduziert bleiben.

Zur Lösung dieses Problems sieht die Erfindung bei einer gattungsgemäßen Schaltungsanordnung mit einer parallel zu der Kollektor-Gate-Strecke des Leistungshalbleiters angeordneten Spannungsklemmbeschaltung, umfassend zwei oder mehrere, in Reihe geschaltete Zenerdioden, vor, daß wenigstens eine Zenerdiode durch einen Kondensator und/oder ein RC-Netzwerk überbrückt ist. Eine derartige Überbrückungsschaltung stellt einen wechselspannungsmäßigen bzw. hochpaßartigen Kurzschluß der überbrückten Zenerdiode dar und reduziert somit dynamisch die Zenerspannung auf den (die) Wert(e) der übrigen Zenerdiode(n). Dadurch ist es möglich, die dynamische Zenerspannung auf einen Wert unterhalb der Zwischenkreisspannung festzulegen, so daß der Einsatzpunkt der Spannungsklemmbeschaltung unter das Zwischenkreisspannungsniveau und somit zeitlich vor das Auftreten einer dynamischen Überspannung verlegt werden kann. Dadurch ist es möglich, den Ansprechzeitpunkt der Spannungsklemmbeschaltung optimal zu wählen: Einerseits kann der Abschaltvorgang zunächst mit einer optimal kurzen Verzögerungszeit durchgeführt werden, jedoch setzt bereits vor dem Auftreten der eigentlichen Überspannung die Regelung der Gatespannung und damit des Durchlaßverhaltens des Leistungshalbleiters ein, so daß die Spannungsbegrenzung bei Auftreten einer Überspannung bereits voll aktiviert ist und keinerlei Überschwingungen auftreten können. Da diese vorteilhaften Wirkungen mit einem äußerst geringen Bauteilaufwand erreicht wird, ist der notwendige Zusatzaufwand äußerst gering.

Es liegt im Rahmen der Erfindung, daß der Überbrückungszweig durch einen Kondensator und einen zu diesem in Reihe geschalteten Bedämpfungswiderstand gebildet ist. Ein derartiges Netzwerk realisiert mit einfachen Mitteln die angestrebte Hochpaßfunktion.

Es hat sich als günstig erwiesen, daß die dem Gateanschluß nächstgelegene(n) Zenerdiode(n) überbrückt ist (sind). Solchenfalls bewegt sich der gateseitige Anschluß des Überbrückungszweiges stets in der Nähe des Gatepotentials des Leistungshalbleiters und somit im Bereich der Versorgungsspannungen der Ansteuerelektronik, so daß eine Einflußnahme auf den Überbrückungszweig, bspw. zur Entladung des Überbrückungskondensators, auf einfachstem Weg möglich ist.

Weitere Vorteile ergeben sich durch eine oder mehrere in den Zweigen der Spannungsklemmbeschaltung angeordnete Dioden, deren Durchlaßrichtung vom Kollektoranschluß zum Gateanschluß weist. Diese Dioden sorgen dafür, daß die Spannungsklemmbeschaltung in eingeschaltenem Zustand des Leistungshalbleiters wirkungslos ist. Die einfachste Anordnung ergibt sich, wenn der überbrückte Zenerzweig mit dem Überbrückungszweig vor der betreffenden Diode zusammengeführt ist. Werden die beiden Zweige dagegen erst am Gateanschluß des Leistungshalbleiters zusammengeführt, ist für jeden der beiden Zweige eine eigene Diode notwendig.

Um andererseits den während einer Abschaltphase aufgeladenen Überbrückungskondensator für einen nächsten Abschaltvorgang wieder entladen zu können, ist ferner eine Diode vorgesehen, welche den gateseitigen Anschluß des Überbrückungszweigs und/oder -kondensators mit der Emitterspannung des Leistungshalbleiters oder mit einem Potential der Ansteuerschaltung verbindet, wobei die Durchlaßrichtung der Diode zum Überbrückungszweig und/oder -kondensator weist. Hierdurch wird bei einem auf einen Abschaltvorgang folgenden Einschalten des Leistungshalbleiters mit dem Absinken von dessen Kollektorpotential auch die Spannungsklemmbeschaltung etwa bis auf das Bezugspotential der Ansteuerschaltung herabgezogen, und die erfindungsgemäße Entladediode erlaubt es hierbei der Kondensatorladung, über die nichtüberbrückten Zenerdioden der Spannungsklemmbeschaltung, die Kollektor-Emitter-Strecke des Leistungshalbleiters, ggf. die damit verbundene Bezugsspannung der Ansteuerschaltung sowie die erfindungsgemäße Entladediode abfließen zu können.

Die Erfindung sieht weiterhin vor, daß in dem Zenerzweig ein Bedämpfungswiderstand angeordnet ist. Dieser stabilisiert den Arbeitspunkt der Zenerdioden.

Eine besonders günstige Weiterbildung der Erfindung besteht darin, daß im Bereich des gateseitigen Anschlusses in der Spannungsklemmbeschaltung, insbesondere in deren Zenerzweig, ein Meßwiderstand zur Strom-Spannungs-Wandlung mit einem daran angekoppelten Verstärker, bzw. einem Spannungs- und/oder Emitterfolger angeordnet ist. Ein derartiger Spannungs- und/oder Emitterfolger kann als Stromverstärker angesehen werden, der den zur Umladung der parasitären Gatekapazität notwendigen Ladestrom niederohmig zur Verfügung stellt, so daß der eigentliche Zenerzweig relativ hochohmig ausgebildet werden kann. Besonders günstig ist diese Anordnung, wenn der überbrückte Zenerzweig mit dem Überbrückungszweig vor bzw. oberhalb des Meßwiderstandes wieder zusammengeführt ist, so daß auch der durch den Kondensatorzweig fließende Überbrückungsstrom von dem Meßwiderstand erfaßt und von dem angekoppelten Spannungs- und/oder Emitterfolger verstärkt wird. Hierdurch kann der Wert des Überbrückungskondensators reduziert werden, so daß die Anordnung äußerst platzsparend und mit geringstem Aufwand realisiert werden kann.

Wenn der Spannungs- und/oder Ermitterfolger aus der Versorgungsspannung der Ansteuerschaltung gespeist wird, kann der Umladestrom des Gateanschlußes mit geringsten Verlusten zur Verfügung gestellt werden, so daß der Wirkungsgrad des Stromrichters verbessert wird.

Eine sinnvolle Weiterbildung der Erfindung besteht darin, daß zwischen dem Treiberausgang der Ansteuerstufe und dem Gateanschluß des Leistungshalbleiters wenigstens ein Gatewiderstand angeordnet ist. Hierdurch kann das Schaltverhalten des Leistungshalbleiters optimal an dessen physikalische Eigenschaften angepaßt werden.

Als besonders günstig hat sich die Verwendung von zwei parallel geschalteten Gatewiderständen erwiesen, wobei in beiden Widerstandszweigen je eine zur anderen antiparallele Diode eingefügt ist. Hierdurch kann der Spannungsanstieg bzw. -abfall in dem Gateanschluß und damit die Einschalt- und Ausschaltzeit des Leistungshalbleiters getrennt vorgegeben werden.

Die Erfindung sieht weiterhin vor, daß an dem Gateanschluß des Leistungshalbleiters ein weiterer, niederohmiger Widerstand angekoppelt ist, der zum Ent- und/oder Umladen der Gatekapazitäten durch einen Halbleiter aktivierbar ist. Hiermit kann einerseits für den eigentlichen Abschaltvorgang ein niedriger Entladewiderstand an die parasitäre Gatekapazität angeschlossen werden, während vor oder bei Erreichen der Zwischenkreisspannung der niederohmige Zusatz-Entladewiderstand abgeschalten wird, damit einerseits die Endphase des Abschaltvorgangs mit einer verlangsamten Geschwindigkeit abläuft, um Überspannungen zu reduzieren, und damit andererseits bei Einsetzen der Spannungsbegrenzung der Spannungsklemmbeschaltung der durch das Zenerdiodennetzwerk fließende-Strom möglichst niedrig bleibt.

Es liegt im Rahmen der Erfindung, daß der Aktivierungs-Halbleiter mit einer Versorgungsspannung der Ansteuerstufe gekoppelt ist. Um für die Entladephase der Gatekapazität einen möglichst großen Spannungshub zur Verfügung zu stellen, bevorzugt die Erfindung hierfür das Potential der negativen bzw. emitterseitig des Leistungshalbleiters liegenden Versorgungsspannung der Ansteuerstufe.

Die Erfindung sieht weiterhin vor, daß der Steuereingang des Aktivierungs-Halbleiters des niederohmigen Zusatzwiderstandes mit einem Steuerschaltkreis gekoppelt ist, der den Aktivierungs-Halbleiter einschaltet, solange die Kollektor-Emitter-Spannung des Leistungshalbleiters eine vorgegebene Spannung nicht überschreitet. Ggf. kann dem Steuerschaltkreis noch das Steuersignal der Ansteuerstufe zugeführt werden, damit dieser Schaltkreis jederzeit den gegenwärtigen Zustand des Leistungshalbleiters und der betreffenden Ansteuerstufe kennt. Es ist daher möglich, den Aktivierungs-Halbleiter ausschließlich während der Abschaltphase, jedoch nicht bis zu dem Ansprechen der Spannungsklemmbeschaltung, einzuschalten.

Schließlich entspricht es der Lehre der Erfindung, daß ein Meßeingang des Steuerschaltkreises für den Aktivierungs-Halbleiter mit einem inneren Verbindungsanschluß der Zenerdiodenreihe verbunden ist, um einen Stromfluß bereits durch eine oder mehrere Zenerdioden zu sensieren. Wenn der Meßeingang des Steuerschaltkreises einen endlichen Eingangswiderstand hat, kann daher bereits ein Stromfluß durch die oberhalb des daran angeschlossenen Knotens der Zenerdiodenreihe liegenden Dioden einsetzen, sobald deren Zenerspannung erreicht ist. Dieser Stromfluß kann von dem Steuerschaltkreis als Indiz dafür gewertet werden kann, daß die Kollektorspannung des Leistungshalbleiters einen Wert erreicht hat, der größer ist als die Durchbruchspannung der oberhalb des Meßeingangs liegenden Zenderdioden. Ist dies der Fall, wird durch Abschalten des angeschlossenen Aktivierungs-Halbleiters die schnelle Entladungsphase der Gatekapazität beendet und dadurch gewährleistet, daß während der folgenden Klemmphase der Spannungsklemmbeschaltung ausschließlich der relativ hochohmige Wert des eigentlichen Gate-Abschaltwiderstands wirksam ist, der relativ wenig Strom zieht und somit die Zenerdiodenreihe nicht zusätzlich belastet.

Weitere Einzelheiten, Merkmale und Vorteile auf der Basis der Erfindung ergeben sich aus der folgenden Beschreibung bevorzugter Ausführungsbeispiele der Erfindung sowie anhand der Zeichnung. Hierbei zeigt:
- Fig. 1: einen Leistungshalbleiter mit idealisiert wiedergegebener Ansteuerschaltung und erfindungsgemäßer Spannungsklemmbeschaltung in deren einfachster Realisierung;
- Fig. 2: eine weitere Ausführungsform der Erfindung mit dem der Figur 1 entsprechenden Schaltungsteil, ergänzt durch einen abschaltbaren Zusatz-Gatewiderstand;
- Fig. 3: eine der Figur 1 entsprechende Darstellung einer weiteren Ausführungsform der Erfindung, mit einem Meßwiderstand in der Spannungsklemmbeschaltung und einem daran angeschlossenen Emitterfolger zur Erhöhung des Umladestroms für die parasitäre Gatekapazität;
- Fig. 4: eine gegenüber der Schaltung nach Figur 3 geringfügig abgewandelte Ausführungsform der Erfindung;
- Fig. 5: eine weitere Ausführungsform der Erfindung, wobei der abschaltbare Gate-Zusatzwiderstand gemäß Figur 2 und der stromverstärkende Emitterfolger gemäß Figur 3 miteinander kombiniert sind; sowie
- Fig. 6: eine wiederum andere Ausführungsform der Erfindung, wobei die Spannungskleimmbeschaltung in besonderen Fällen deaktiviert werden kann.

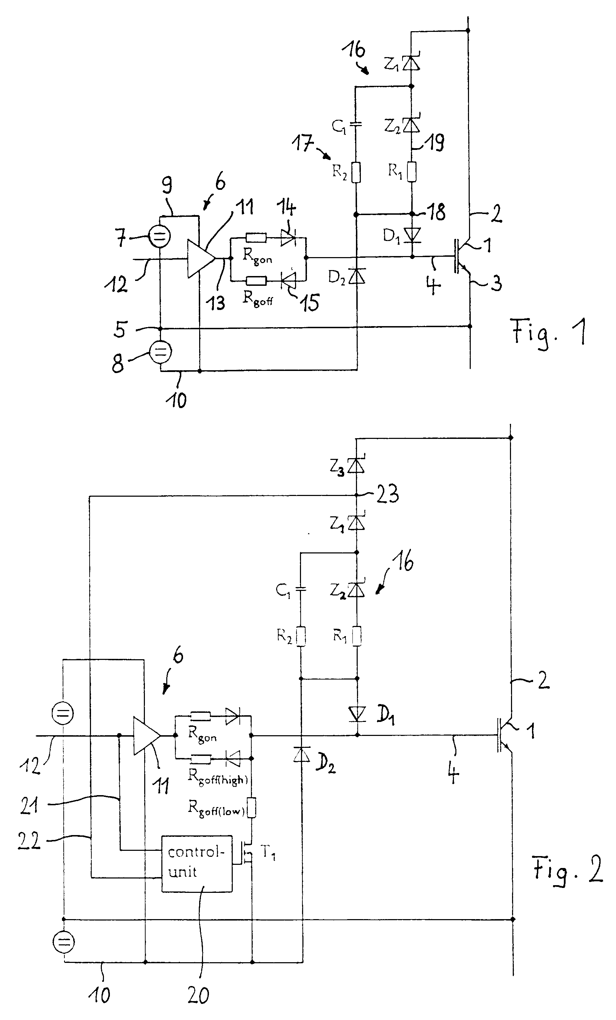

In Figur 1 ist mit 1 ein abschaltbarer Leistungshalbleiter in Form eines Insolated Gate Bipolar-Transistors (IGBT) dargestellt. Sein Kollektoranschluß ist mit 2, der Emitteranschluß mit 3 und der Gateanschluß mit 4 bezeichnet. Das Emitterpotential 3 ist mit dem Bezugspotential 5 der betreffenden Ansteuerstufe 6 verbunden. Symmetrisch zu dem Bezugspotential der Ansteuerstufe 6 sind zwei Konstantspannungsquellen 7, 8 angeschlossen, um eine positive Versorgungsspannung 9 und eine negative Versorgungsspannung 10 für die Ansteuerstufe 6 und insbesondere deren Ausgangs-Treiberstufe 11 zur Verfügung zu stellen. Diese Treiberstufe 11 empfängt eingangsseitig ein Elektronik-Steuersignal 12 und stellt dieses an ihrem Ausgang 13 niederohmig zur Verfügung, um durch Gatewiderstände Rgon, Rgoff den Gateanschluß 4 des Leistungshalbleiters 1 anzusteuern. Durch zwei antiparallele, mit je einem der beiden Gatewiderstände Rgon, Rgoff in Reihe liegende Dioden 14, 15 wird je nach dem Spannungsabfall zwischen dem Treiberausgang 13 und dem Gateanschluß 4 der Einschaltwiderstand Rgon oder der Ausschaltwiderstand Rgoff aktiviert. Hierdurch ist es möglich, die Umladephasen der an dem Gateanschluß 4 vorhandenen, parasitären Gatekapazität während der Ein- und Ausschaltphasen des Leistungshalbleiters 1 unabhängig voneinander vorzugeben.

Um während einer Abschaltphase des Leistungshalbleiters 1 an dessen Kollektoranschluß 2 durch parasitäre Induktivitäten in dem Kommutierungskreis verursachte, dynamische Überspannungen zu begrenzen, sieht die Erfindung eine Spannungsklemmbeschaltung 16 zwischen dem Kollektoranschluß 2 und dem Gateanschluß 4 des Leistungshalbleiters 1 vor. Diese Spannungsklemmbeschaltung 16 besteht aus zwei in Serie geschaltenen Zenerdioden Z1, Z2, wobei die Zenerdiode Z1 einseitig mit dem Kollektoranschluß 2 des Leistungshalbleiters 1 verbunden und wie auch die Zenerdiode Z2 derart gepolt ist, daß die charakteristische Zener-Durchbruchspannung bei einem Spannungsabfall von dem Kollektoranschluß 2 in Richtung zu dem Gateanschluß 4 des Leistungshalbleiters 1 wirksam wird. Der freie Anschluß der Zenerdiode Z2 ist über einen Bedämpfungswiderstand R1 zur Einstellung des Arbeitspunktes und eine mit diesem in Reihe geschaltete Diode D1 mit dem Gateanschluß 4 verbunden. Die Diode D1 hat die Aufgabe, die Spannungsklemmbeschaltung 16 bei eingeschaltenem Leistungshalbleiter 1 und somit niedrigem Kollektorpotential 2 von dem Gateanschluß 4 abzutrennen und ist daher mit ihrer Durchlaßrichtung vom Kollektoranschluß 2 zum Gateanschluß 4 des Leistungshalbleiters 1 gepolt.

Die Zenerdioden Z1 und Z2 sind derart ausgelegt, daß die Summe ihrer Durchbruchspannungen höher ist als die Zwischenkreisspannung des betreffenden Stromrichters, so daß ein Kurzschluß des Spannungszwischenkreises ausgeschlossen ist. Damit dennoch die erfindungsgemäße Spannungsklemmbeschaltung 16 bereits in Aktion treten kann, bevor das Kollektorpotential 2 des Leistungshalbleiters 1 das Niveau der Zwischenkreisspannung erreicht hat, wird eine der beiden Zenerdioden Z2 dynamisch durch ein RC-Netzwerk 17 überbrückt. Dieses besteht aus einem Überbrückungskondensator C1 und einem damit in Serie gestalteten Bedämpfungswiderstand R2 und hat somit die Charakteristik eines Hochpaßes. Diese RC-Beschaltung liegt parallel zu der Zenerdiode Z2 und dem Bedämpfungswiderstand R1.

Sobald die Spannung zwischen dem Kollektoranschluß 2 und dem Gateanschluß 4 des Leistungshalbleiters 1 die Durchbruchspannung der Zenerdiode Z1 entspricht, kann durch das RC-Netzwerk 17 und die Diode D1 ein Strom zu dem Gateanschluß 4 des Leistungshalbleiters 1 fließen und dort zunächst die parasitäre Gatekapazität wieder aufladen bis zu einem Wert knapp unterhalb der Einschaltspannung des Leistungshalbleiters 1, so daß in einer zweiten Phase, falls eine dynamische Überspannung an dem Kollektoranschluß 2 auftritt, welche größer ist als die Summe der Durchbruchspannungen der Zenerdioden Z1 und Z2, ein permanenter, zusätzlicher Ladestrom zu dem Gateanschluß 4 des Leistungshalbleiters 1 fließen kann und diesen wieder soweit aufsteuern kann, daß die Überspannung an dessen Kollektoranschluß 2 sofort kurzgeschlossen wird. Dies erfolgt nahezu verzögerungsfrei und somit ohne merkliches Überschwingen.

Der Kondensator C1 bleibt aufgeladen, bis der Leistungshalbleiter 1 abermals eingeschalten wird. Mit Absinken der Kollektorspannung 2 sinkt auch das Potential des RC-Netzwerks 17 ab, bis dieses etwa das Bezugspotential 5 erreicht hat. Um während dieser Phase eine Entladung des Kondensators C1 zu ermöglichen, ist an dem Vereinigungspunkt 18 des Zenerzweigs 19 mit dem Überbrückungszweig 17 eine weitere Diode D2 angeschlossen, die mit ihrer anderen Elektrode an der negativen Versorgungsspannung 10 der Ansteuerstufe 6 angeschlossen und derart gepolt ist, daß sich ein Entladestrom des Überbrückungskondensators C1 über die obere Zenerdiode Z1, den Leistungshalbleiter 1, das Bezugspotential 5 der Ansteuerstufe 6, deren Konstantspannungsquelle 8, die Diode D2 und der Bedämpfungswiderstand R2 schließen kann. Der Kondensator Z1 kann auf diesem Weg auf eine Spannung entladen werden, welche etwa der Konstantspannung 8 entspricht. Der Kondensator C1 ist somit für einen weiteren Stromstoß bei der nächst folgenden Abschaltphase vorbereitet.

Die Schaltung nach Figur 1 weist eine zur Unterdrückung von dynamischen Überspannungen optimale Dynamik auf. Anderererseits belastet der Entladewiderstand Rgoff die Spannungsklemmbeschaltung 16 während deren aktiver Klemmphase, so daß nur ein Teil des durch diese Spannungsklemmbeschaltung 16 hindurchfließenden Stroms zur Wiederaufladung der parasitären Gatekapazität zur Verfügung steht. Hier erreicht die Schaltung gemäß Figur 2 eine weitere Verbesserung. Diese entspricht hinsichtlich des Leistungshalbleiters 1, der Ansteuerstufe 6 und der Bauteile Z1, Z2, R1, R2, D1, D2 und C1 der Spannungsklemmbeschaltung 16 der Schaltungsanordnung gemäß Figur 1. Um die Spannungsklemmbeschaltung 16 während deren Klemmphase möglichst wenig durch den Gate-Ausschaltwiderstand Rgoff zu belasten, ist hier der Gate-Ausschaltwiderstand aufgeteilt in einen hochohmigen Ausschaltwiderstand Rgoff(high) und einen niederohmigen Ausschaltwiderstand Rgoff(low). Der Widerstand Rgoff(hifh) ist immer in Eingriff und derart hochohmig, daß dadurch die Spannungsklemmbeschaltung 16 kaum belastet wird. Damit dennoch während des ersten Teils der Abschaltphase, bis die Kollektorspannung 2 des Leistungshalbleiters 1 in den Bereich der Zwischenkreisspannung ansteigt und dadurch die Spannungsklemmbeschaltung 16 aktiviert wird, die in der parasitären Gatekapazität gespeicherte Ladung schnell abfließen kann, wird während dieser Phase über einen MOSFET T1 ein zusätzlicher, niederohmiger Gate-Entladewiderstand Rgoff(low) zwischen dem Gateanschluß 4 und der negativen Versorgungsspannung 10 der Ansteuerstufe 6 aktiviert. Der MOSFET T1 wird von einem Steuerschaltkreis 20 eingeschalten, wenn an dem Steuereingang 12 der Ansteuerstufe 6 eine Einschaltflanke sensiert 21 wird. Um den MOSFET T1 rechtzeitig vor der Klemmphase der Spannungsklemmbeschaltung 16 ausschalten zu können, ist ein Steuereingang 22 des Steuerschaltkreises 20 mit der Spannungsklemmbeschaltung 16 verbunden. Hier ist zusätzlich zu der Schaltung gemäß Figur 1 eine weitere Zenerdiode Z3 vorgesehen, welche das freie Ende der Zenerdiode Z1 mit dem Kollektoranschluß 2 des Leistungslbleiters 1 verbindet. Hierdurch ergibt sich ein weiterer innerer Knoten 23 in der Zenerdiodenreihe Z1, Z2, Z3, der mit dem Steuereingang des Steuerschaltkreises 20 verbunden ist. Der Steuerschaltkreis 20 hat an seinem Steuereingang 22 einen endlichen Eingangswiderstand, so daß durch die Zenerdiode Z3 und diesen Eingangswiderstand ein Strom fließen kann. Nun wird der MOSFET T1 ausgeschalten und damit der niederohmige Abschaltwiderstand Rgoff(low)) deaktiviert. Steigt nun die Kollektorspannung 2 weiter, bis sie in die Nähe der Zwischenkreisspannung gelangt, wird die Summe der Durchbruchspannungen der Zenerdioden Z3, Z1 überschritten, und nun tritt der Hochpaß-Effekt des RC-Netzwerks 17 in derselben Form auf wie bei der Schaltung nach Figur 1, wobei die parasitäre Gatekapazität des Leistungshalbleiters 1 bis knapp unterhalb von dessen Einschaltschwelle aufgeladen wird. Tritt eine dynamische Überspannung auf, die zusammen mit der Zwischenkreisspannung größer ist als die Summe der Durchbruchspannungen der Zenerdiodenreihe Z1, Z2, Z3, fließt ein permanenter Ladestrom und schaltet den Leistungshalbleiter 1 ein, um die Überspannung kurzzuschließen.

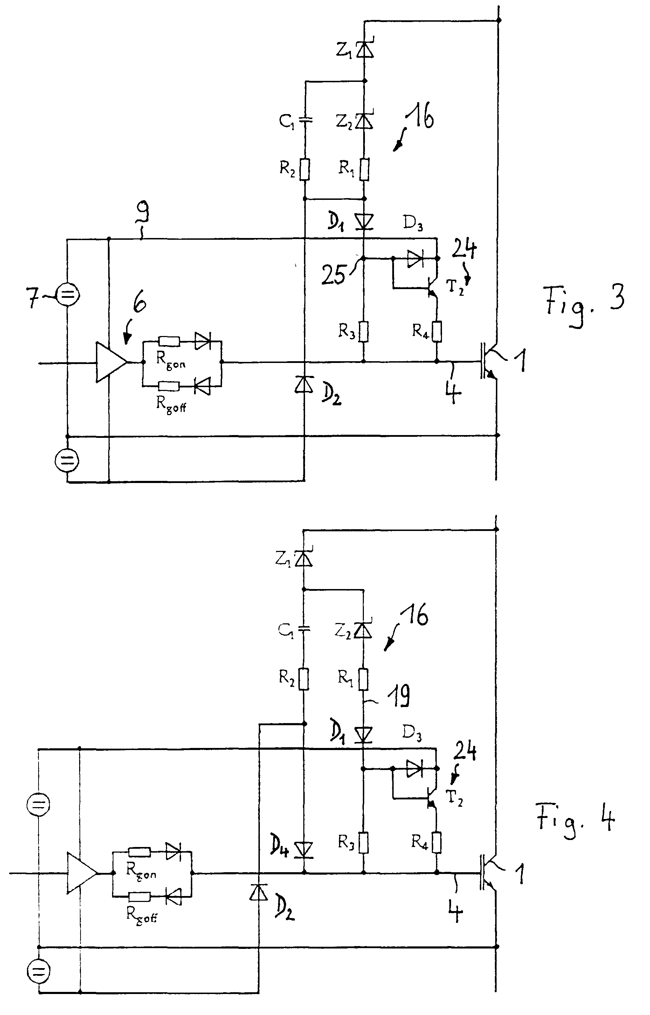

Eine andere Möglichkeit, um die Spannungsklemmbeschaltung 16 während deren Klemmphase zu entlasten, ist in Figur 3 wiedergegeben. Diese entspricht weitgehend der Figur 1 mit Ausnahme eines zwischen die Diode D1 und dem Gateanschluß 4 des Leistungshalbleiters 1 eingefügten Meßwiderstandes R3, dessen zu dem Strom der Spannungsklemmbeschaltung 16 proportionale Spannungsabfall durch einen von einem Bipolartransistor T2 samt Emitterwiderstand R4 gebildeten Emitterfolger 24 niederohmig zur Aufladung einer Gatekapazität zur Verfügung gestellt wird. Der Bipolartransistor T2 dieses Emitterfolgers 24 ist zur Reduzierung der Verlustleistung mit seinem Kollektor an der positiven Versorgungsspannung 9 der Ansteuerstufe 6 angeschlossen. Eine zwischen die Eingangsspannung 25 des Emitterfolgers und die positive Versorgungsspannung 9 der Ansteuerstufe 6 geschaltete Diode D3 begrenzt die Eingangsspannung 25 des Emitterfolgers 24 und vermeidet somit ein Übersteuern desselben. Der Emitterfolger-Verstärker 24 sorgt dafür, daß die parasitäre Gatekapazität auch mit einer hochohmigen Spannungsklemmbeschaltung 16 problemlos umgeladen werden kann, so daß die Verlustleistung der Spannungsklemmbeschaffung 16 weiter reduziert werden kann.

Eine ähnliche Wirkung hat die Schaltungsanordnung gemäß Figur 4. Diese unterscheidet sich von der Schaltung gemäß Figur 3 ausschließlich dadurch, daß hier ausschließlich der durch den Zenerzweig 19 fließende Strom einen Spannungsabfall an den Meßwiderstand R3 verursacht und somit durch den Emitterfolger 24 verstärkt wird, während ein dynamischer Ladestrom des Überbrückungskondensators C1 in dem RC-Netzwerk 17 direkt auf den Gateanschluß 4 einwirkt. Durch die direkte Koppelung des Überbrückungszweigs 17 mit dem Gateanschluß 4 erreicht diese Schaltung eine optimale Dynamik, während die Verlustleistung gegenüber der Schaltung gemäß Figur 3 nur geringfügig verschlechtert ist.

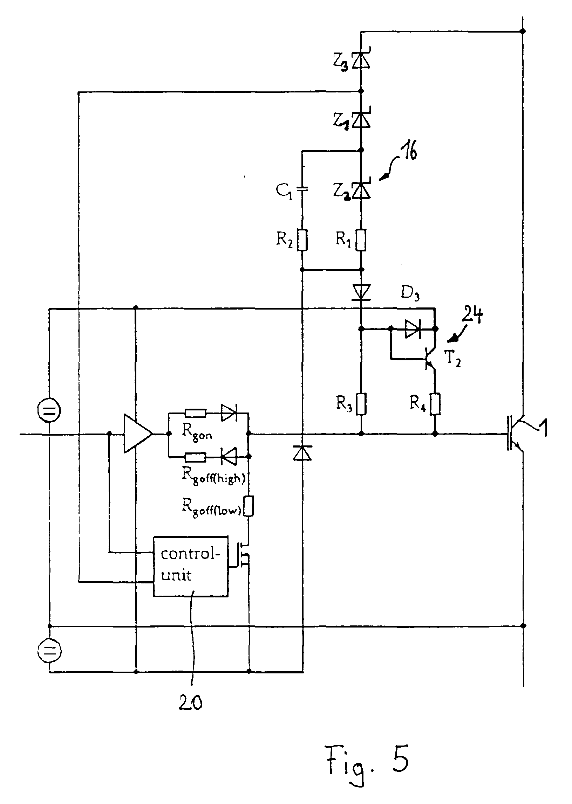

Bei der Schaltung gemäß Figur 5 ist die erfindungsgemäße Spannungsklemmbeschaltung 16 gemäß Figur 1 mit dem dynamisch angesteuerten 20 Zusatz-Gate-Entladewiderstand Rgoff(low) nach Figur 2 und dem niederohmigen Emitterfolger 24 gemäß Figur 3 kombiniert und stellt somit eine besonders verlustarme Ausführungsform mit einer optimalen Dynamik der Spannungsklemmbeschaltung 16 dar.

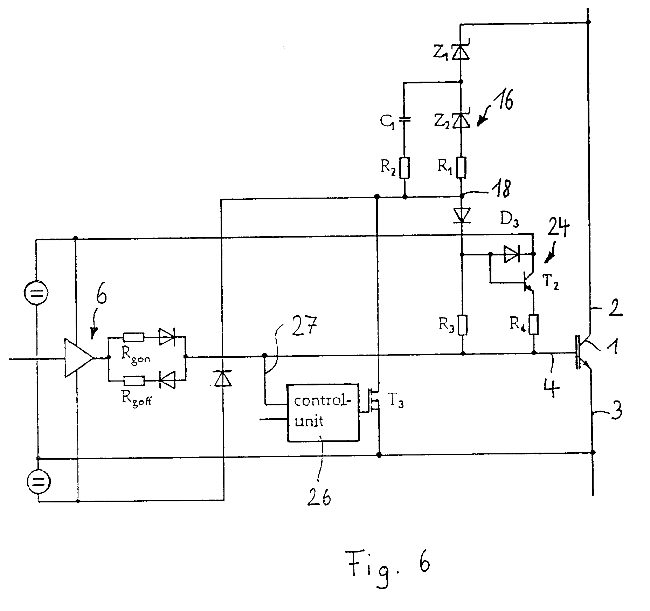

Bei Stromrichtern können dynamische Überspannungen nicht nur bei der Kommutierung des Laststroms von einem steuerbaren Leistungshalbleiter auf eine daran angeschlossene Freilaufdiode auftreten, sondern auch dann, wenn die zu dem betreffenden steuerbaren Leistungshalbleiter 1 antiparallele Freilaufdiode vom Durchlaß- in den Sperrzustand schaltet. Auch in diesem Fall steigt die Kollektorspannung 2 des Leistungshalbleiters 1 schnell an und könnte daher zu einem Ansprechen der Spannungsklemmbeschaltung 16 führen. Um dies zu vermeiden, kann bspw. der Transistor T1 gemäß Figur 2 wieder eingeschaltet werden, um den niederohmigen Gate-Entladewiderstand Rgoff(low) abermals zu aktivieren. Als Kriterium für die Erkennung eines derartigen passiven Schaltvorgangs kann bspw. eine besonders niedrige Gate-Emitter-Spannung des Leistungshalbleiters 1 herangezogen werden, die zu diesem Zweck mit einer vorgegebenen Schaltschwelle verglichen werden kann. Ist ein derartiger, niederohmiger Gate-Entladewiderstand Rgoff (low) nicht vorhanden, kann die Schaltungsanordnung nach Figur 6 verwendet werden. Diese unterscheidet sich von der Schaltung gemäß Figur 3 vor allem durch einen zusätzlich MOSFET T3 mit dem der Vereinigungsknoten 18 zwischen dem Zenerzweig 10 und dem Überbrückungszweig 17 der Spannungsklemmbeschaltung 16 mit dem Emitterpotential 3 des Leistungshalbleiters 1 kurzgeschlossen werden kann. Somit kann von der Spannungskleimmbeschaltung 16 das Potential an dem Gateanschluß 4 des Leistungshalbleiters 1 nicht über dessen Einschaltschwelle angehoben werden. Der Gateanschluß des MOSFET T3 wird von einem Steuerschaltkreis 26 angesteuert, der mit einem Steuereingang 27 an den Gateanschluß 4 des Leistungshalbleiters 1 angeschlossen ist, um dessen Entladezustand zu sensieren. Der Steuerschaltkreis 26 ist intern derart aufgebaut, daß der MOSFET T3 ausschließlich dann eingeschalten wird, wenn der Leistungshalbleiter 1 infolge einer besonders niedrigen Gatespannung sicher ausgeschalten ist. Hierdurch wird die Spannungsklemmbeschaltung 16 erst dann deaktiviert, wenn die Gefahr einer durch den Abschaltvorgang des Leistungshalbleiters 1 ausgelösten Überspannung vollständig gebannt ist.

## Patentansprüche

1. Schaltungsanordnung zur Begrenzung von dynamischen Überspannungen beim Abschalten von spannungsgesteuerten Leistungshalbleitern (1) mit einer parallel zu der Kollektor-Gate-Strecke des Leistungshalbleiters (1) angeordneten Spannungsklemmbeschaltung (16), umfassend zwei oder mehrere in Reihe geschaltete Zenerdioden (Z1, Z2), **dadurch gekennzeichnet,** daß wenigstens eine Zenerdiode (Z2) durch einen Kondensator (C1) und/oder ein RC-Netzwerk (17) überbrückt ist.

2. Schaltungsanordnung nach Anspruch 1, **dadurch gekennzeichnet,** daß der Überbrückungszweig (17) durch einen Kondensator (C1) und einen zu diesem in Reihe geschalteten Bedämpfungswiderstand (R2) gebildet ist.

3. Schaltungsanordnung nach Anspruch 1 oder 2, **dadurch gekennzeichnet,** daß die dem Gateanschluß (4) nächstgelegene(n) Zenerdiode(n) (Z2) überbrückt ist (sind).

4. Schaltungsanordnung nach einem der vorhergehenden Ansprüche, **gekennzeichnet** durch eine oder mehrere, in den Zweigen (17, 19) der Spannungskleimmbeschaltung (16) angeordnete Dioden (D1, D4), deren Durchlaßrichtung vom Kollektoranschluß (2) zum Gateanschluß (4) weist.

5. Schaltungsanordnung nach Anspruch 4, **gekennzeichnet** durch eine außerhalb des verzweigten Bereichs (17, 19) der Spannungsklemmbeschaltung (16) angeordnete Diode (D1).

6. Schaltungsanordnung nach Anspruch 4, **dadurch gekennzeichnet,** daß sowohl im Zenerzweig (19) als auch im Überbrückungszweig (17) je eine Diode (D1, D4) angeordnet ist.

7. Schaltungsanordnung nach einem der vorhergehenden Ansprüche, **gekennzeichnet** durch eine Diode (D2), welche den gateseitigen Anschluß des Überbrückungszweigs (17) und/oder -kondensators (C1) mit der Emitterspannung (3) des Leistungshalbleiters (1) oder mit einem Potential (10) der Ansteuerschaltung (6) verbindet, wobei die Durchlaßrichtung der Diode (D2) zu dem Überbrückungszweig (17) und/oder -kondensator (C1) weist.

8. Schaltungsanordnung nach einem der vorhergehenden Ansprüche, **dadurch gekennzeichnet,** daß in dem Zenerzweig (19) ein Bedämpfungswiderstand (R1) angeordnet ist.

9. Schaltungsanordnung nach einem der vorhergehenden Ansprüche, **dadurch gekennzeichnet,** daß im Bereich des gateseitigen Anschlusses in der Spannungsklemmbeschaltung (16), insbesondere in deren Zenerzweig (19), ein Meßwiderstand (R3) zur Strom-Spannungs-Wandlung mit einem daran angekoppelten Verstärker, insbesondere einem Spannungs- und/oder Emitterfolger (24) angeordnet ist.

10. Schaltungsanordnung nach Anspruch 9, **dadurch gekennzeichnet,** daß der Spannungs- und/oder Emitterfolger (24) aus der Versorgungsspannung (9) der Ansteuerschaltung (6) gespeist wird.

11. Schaltungsanordnung nach einem der vorhergehenden Ansprüche, **dadurch gekennzeichnet,** daß zwischen dem Treiberausgang (13) der Ansteuerstufe (6) und dem Gateanschluß (4) des Leistungshalbleiters (1) wenigstens ein Gatewiderstand (Rgon, Rgoff) angeordnet ist.

12. Schaltungsanordnung nach Anspruch 11, **gekennzeichnet** durch zwei parallel geschaltete Gatewiderstände (Rgon, Rgoff), wobei in beiden Widerstandszweigen je eine zur anderen antiparallele Diode (14, 15) eingefügt ist.

13. Schaltungsanordnung nach einem der vorhergehenden Ansprüche, **dadurch gekennzeichnet,** daß an dem Gateanschluß (4) des Leistungshalbleiters (1) ein weiterer, niederohmiger Widerstand (Rgoff (low)) angekoppelt ist, der zum Ent- und/oder Umladen der Gatekapazitäten durch einen Halbleiter (T1) aktivierbar ist.

14. Schaltungsanordnung nach Anspruch 13, **dadurch gekennzeichnet,** daß der AktivierungsHalbleiter (T1) mit einer Versorgungsspannung (10) der Ansteuerstufe (6) gekoppelt ist.

15. Schaltungsanordnung nach Anspruch 13 oder 14, **dadurch gekennzeichnet,** daß der Steuereingang des Aktivierungs-Halbleiters (T1) mit einem Steuerschaltkreis (20) gekoppelt ist, der den Aktivierungs-Halbleiter (T1) einschaltet, solange die Kollektor-Emitter-Spannung des Leistungshalbleiters (1) eine vorgegebene Spannung nicht überschreitet.

16. Schaltungsanordnung nach Anspruch 15, **dadurch gekennzeichnet,** daß ein Meßeingang (22) des Steuerschaltkreises (20) mit einem inneren Verbindungsanschluß (23) der Zenerdiodenreihe (Z1-Z3) verbunden ist, um einen Stromfluß durch eine oder mehrere Zenerdioden (Z3) zu sensieren.
